Europäisches Patentamt

(19) European Patent Office

Office européen des brevets

(11) Publication number: **0 009 535**
**B1**

(12) **EUROPEAN PATENT SPECIFICATION**

(45) Date of publication of patent specification: **14.10.81**

(21) Application number: **79102156.1**

(22) Date of filing: **28.06.79**

(51) Int. Cl.³: **G 01 N 24/04,**
**G 01 N 24/08**

(54) **Spinning apparatus for nuclear magnetic resonance spectrometers, and spectrometer incorporating this spinning apparatus.**

(30) Priority: **04.08.78 US 930846**

(43) Date of publication of application:
**16.04.80 Bulletin 80/8**

(45) Publication of the grant of the European patent:
**14.10.81 Bulletin 81/41**

(84) Designated Contracting States:
**DE FR GB**

(56) References cited:
**DD - A - 136 769**
**DE - A1 - 2 743 943**
**GB - A - 1 158 876**
**US - A - 2 960 649**
**US - A - 3 100 866**
**US - A - 3 512 078**
**US - A - 3 746 971**

(73) Proprietor: **International Business Machines**
**Corporation**
**Armonk, N.Y. 10504 (US)**

(72) Inventor: **Fyfe, Colin Alan**
**26 Cedar Street**
**Guelph, Ontario (CA)**
Inventor: **Mossbrugger, Horst Gerhardt**
**6340 Farmhill Way**
**San Jose, ÇA 95120 (US)**
Inventor: **Yannoni, Costantino, Sheldon**
**19590 Black Road**
**Los Gatos, CA 95030 (US)**

(74) Representative: **Lancaster, James Donald**
**Rablstrasse 24**
**D-8000 München 80 (DE)**

Courier Press, Leamington Spa, England.

## Spinning apparatus for nuclear magnetic resonance spectrometers, and spectrometer incorporating this spinning apparatus

This invention relates to nuclear magnetic resonance (NMR) spectrometers, and it particularly pertains to gas driven spinning apparatus having a gas-bearing, for spinning a sample of material.

Nuclear magnetic resonance spectroscopy has been known for a number of decades. An NMR spectrometer may comprise an apparatus wherein a spinnable sample is rotated at substantially steady speeds about an axis of rotation intersecting the axis of a magnetic field set up in a gap extending between two opposed poles of a magnet. Formerly the sample has been mounted in a rotor assembly which is itself pivotally mounted by a complex structure within a probe slidable along guideways into and out of the magnet gap. Various probe arrangements have been suggested to date, but are unsatisfactory for a number of reasons.

Representative prior art is found in the following U.S. Patents:

| | | | |
|---|---|---|---|
| 2,906,649 | 11/1960 | BLOCH | 324/0.5 |
| 3,172,035 | 3/1965 | ARNOLD ET AL | 324/0.5 |
| 3,462,677 | 8/1969 | PAITICH | 324/0.5 |
| 3,568,047 | 3/1971 | LOOK ET AL | 324/0.5 |
| 3,588,677 | 6/1971 | KLELMAN ET AL | 324/0.5 |
| 3,681,683 | 8/1972 | HUBER | 324/0.5R |
| 3,746,971 | 7/1973 | STOREY ET AL | 324/0.5R |
| 3,796,946 | 3/1974 | UTSUMI ET AL | 324/0.5R |
| 3,911,355 | 10/1975 | LEANE ET AL | 324/0.5AH |

and in the following published technical literature:

A. C. Cunningham and S. M. Day; "Pulsed NMR of $Na^{23}$ in Rapidly Rotated NaCl"; Physical Review; Vol 152, Nr. 1; 1966; p 289

H. Kessemeyer and R. E. Norberg; "Pulsed NMR in Rotating Solids"; Physical Review; Vol 155, Nr 2; 1967; p 321.

E. R. Andrew; "The Narrowing of NMR Spectra of Solids by High Speed Specimen Rotation and The Resolution of Chemical Shift and Spin Multiplet Structures for Solids"; Progress in NMR Spectroscopy, Volume 8, Nr 1; 1971; pp 25—6.

(Author unidentified); "Magnetic Resonance in Chemistry and Biology"; Proceedings International Summer School, Yugoslavia; 1971; Figs. 7 & 8.

E. L. Stejskal, et al; "Carbon-13 NMR of Adsorbed $CO_2$"; Journal of Chemical Physics, Vol 61, Nr. 6; 1974; p 2351.

Known spinning apparatus tends to be unreliable and of a complex construction that frequently leaves the apparatus difficult to insert and to withdraw from conventional spectrometers, and makes it difficult to align the axis of the spinning at a precise angle to one or more of the normal axes of the structure of the spectrometer.

Patent specification DD 136 769 discloses a spinning apparatus having a rotatable sample holder located in the axial bore of a coil spool, the coil spool being surrounded by a housing comprising a sleeve and two end plates. The sample holder has conical ends, each with a series of flutes spaced around it. The coil spool has channels through which gas is directed to provide a gas bearing for the sample holder, and impeller gas jets which impinge on the series of flutes and cause the sample holder to rotate, the gas escaping through openings in the end plates. The housing containing the sample holder is mounted in a probe which is positioned between the magnetic poles of a nuclear magnetic resonance spectrometer. In order to access the sample holder, the probe is first removed from the spectrometer, the housing containing the sample holder is removed from the probe, and the sample holder is then withdrawn from the housing by the apparent procedure of removing one of the end plates. Specifically removal of the sleeve of the housing does not give access to the sample holder, and the sleeve does not form part of a chamber in which the gas bearing is formed, this chamber being formed in the axial bore of the coil spool. No details are given regarding any design feature for enabling the spin axis of the sample holder to be aligned in the spectrometer.

According to the invention there is provided spinning apparatus for nuclear magnetic resonance spectrometers, characterised by a non-magnetic assembly comprising a body member (52) having a sleeve (58) which is displaceable from a first position relative to the body member to allow a sample or sample holder (70) to be inserted in or removed from a chamber formed between the body member and the sleeve when in the said first position, the chamber having a gas flow path therethrough for forming a gas bearing on which the sample or sample holder is rotatable by the gas.

In this arrangement the sleeve has a dual function, to allow placement and removal of samples, and partly to form the chamber in which the gas bearing is produced in operation. This is a very simple structure. Embodiments can be constructed, as will be apparent from the later description herein, which are very compact.

Also according to the invention there is provided a nuclear magnetic resonance spectrometer including spinning apparatus as above, so mounted that the spin axis of the sample or sample holder lies in the plane defined by a high dc magnetic field axis of the spectrometer, and the axis of an excitation coil of the spectrometer associated with the spinning apparatus.

In the accompanying drawings:—

FIG. 1 is a diagrammatic illustration of an NMR spectrometer including a spinning apparatus according to the invention;

FIG. 2 is an exploded, partly-sectioned, enlarged diagram of the spinning apparatus of Fig. 1;

FIGS. 3 and 4 are diagrams each showing a different relationship between the various axes of the spectrometer and the spinning apparatus of Fig. 1;

FIG. 5 is a cross-section view of an alternative embodiment of NMR spinning apparatus according to the invention.

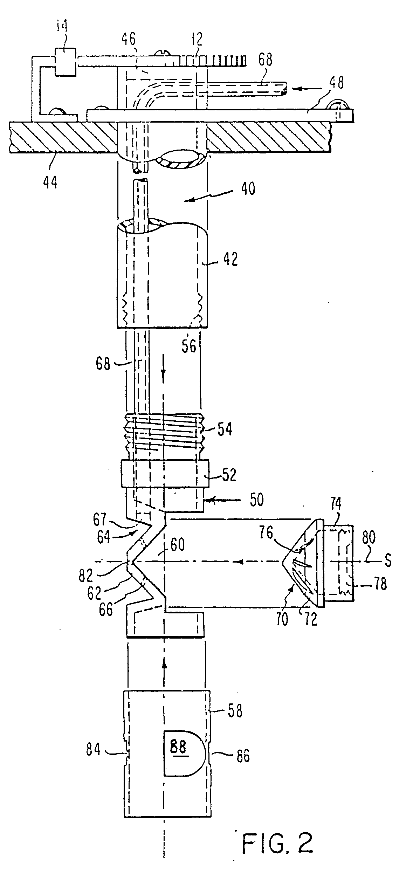

Referring to FIG. 1, the spinning apparatus is shown here only generally as a cylindrical member 10 at the upper end of which there is affixed a dial plate 12 for cooperating with an index pointer 14. These components will be more completely described hereinafter. The spectrometer has a magnet assembly 16 of generally C-shaped configuration with two pole faces 22 and 23 between which the spinning apparatus is arranged as shown. A strong static dc magnetic field $H_o$ is established by means of a pair of windings 24 and 25 in conventional manner. The turns of a solenoid winding or coil 26 surround the cylindrical member 10 while another solenoid winding 30 is wound in two sections 31 and 32 about the first winding. A Faraday shield (not shown) is provided between the windings 31, 32 of the solenoid 30 and the coil 26 to reduce the electrostatic coupling therebetween to a minimum. The axes of the coils 26 and 30 are at 90°C whereby the magnetic coupling therebetween approaches zero. However, it is conventional to introduce some leakage coupling therebetween in many nuclear magnetic resonance (NMR) spectrometers for establishing a desired operational mode. The longitudinal axis of the cylindrical member 10, hereinafter termed the X or $P_c$ (pickup coil) axis, is at 90° to the axis of the solenoid winding coil 30, hereinafter termed the Y or $E_c$ (exciting coil), axis and also at 90° to the magnetic field axis. This illustration of the structure is intended to show clearly the component parts and their relationship to each other rather than to show an actual construction to scale. For example, in actual practice the pole faces 22 and 23 are arranged quite close to the central components comprising the coils 26 and 30, and the cylindrical member 10.

The dial plate 12 is preferably divided into divisions totaling 360° and is aligned with the spin axis of a sample holder within the cylindrical member 10 which is to be described hereinafter whereby the sample holder can be aligned readily at a predetermined angle to the Z or $H_o$ axis, read by the pointer 14, and particularly at the angle of 54.7°; this angle stems from a solution of the second Legendre polynomial expression $3 \cos^2 \theta - 1 = 0$. This setting is used for optimizing the operation of an NMR spectrometer.

The cylindrical member 10 will now be described with reference to FIG. 2. A supporting section 40 is shown in the form of a relatively long tube 42 which can readily be slipped into a supporting member 44 shown here in only the barest detail as this supporting structure forms no part of the invention in and of itself. A plug 46 is fixed in the upper end of the tube 42 and holds the dial plate 12 while the tube 42 is held at the desired elevation by any suitable means, for example a spring loaded friction device 48. In the vertical attitude of the tube 42, the device 48 is preferably a spring, loaded scissorlike assembly having opposing V-notches for gripping the tube 42 and holding it in place vertically and centrally between the pole faces of the magnet. The pointer 14 preferably is given a thickness in the vertical direction of the order of the variation in depth to which the tube 42 may be positioned in operation.

A body member 50 comprises a nonmagnetic cylinder 52 of maximum diameter substantially equal to the outside diameter of the tube 42. To form the member 50 from a solid workpiece, the upper end of the cylinder 52 is machined to a smaller diameter and to provide threads 54 which mate with threads 56 within the tube 42. The upper end of the cylinder 52 is bored as shown so that its internal wall lines up with the internal wall of the tube 42. At the lower end, the outer part of the cylinder 52 is cut away so as to be able to receive a displaceable tubular sleeve 58 of maximum diameter substantially equal to the outside diameters of the tube 42 and of the cylinder 52. The sleeve 58 coacts with surfaces of cylinder 52 which lie on a cylinder, and also has apertures machined therein which will be described hereinafter.

About half of the lower end of the cylinder 52 is machined away leaving a plane surface along the longitudinal axis of the cylinder 52. A right cone-shaped recess 60 is then machined out, so that the centre of the base of recess 60 is on the longitudinal axis of the cylinder 52. Then the portion of the cylinder 52 opposite the recess 60 is machined to leave a hollow cone wall 62 and thereabout an annular recess 64. Several gas jet orifices permit communication between the recesses 60 and 64. Only two orifices 66 are shown, but in practice there may be three or four. The cylinder 52 has a tubular bore 67 as shown into which a flexible tube 68 is fitted for admitting gas into the annular recess 64 which forms a manifold for the gas jet orifices 66. When the sleeve member 58 is in place, gas exiting from the tube 68 is forced through the orifices 66 into the recess 60. The purpose of this gas is to form a low friction gas bearing for, and to drive, a rotating sample spinner 70. The latter comprises a cone-headed portion 72 mating with the recess 60 and has a cylindrical body portion 74. The portion 72 has a series of flutes 76 spaced therearound serving as impeller cups for the gas jets. The sample spinner is of maximum dimensions so that it can fit in the chamber formed between the cylinder 52 and the sleeve member 58 when the latter is in place. Apertures 88 on either side of the sleeve member 58 permit escape of gas. The sample spinner 70 rides on a gas bearing formed between the conical inner surface of the wall 62 and the portion 72 of the spinner 70. The portion 72 has two cone angles as shown for importing greater ease in starting up and greater stability in spinning. The skirt section of portion 72 is given an angle, say 44°, close to angle, say 45°, of the recess 60 and the apex section is given a lesser angle by 1—5 degrees, say 39.5°, from the longitudinal axis 80 of the spinner. Optionally, a gas exhaust aperture 82 is located at the apex of the recess 60 and registers with aperture 84 in the sleeve 58, for improving operation of the air bearing. Another gas exhaust aperture 86 can be provided in the sleeve 58 opposite to the aperture 84 for similar purpose. It will be seen that the cone-shaped recess 60 determines the spin axis of the spinner 70.

When the sample material so permits, the spinner 70 can be made entirely of the sample material and the spinner 70 is the sample that is spun. Otherwise the spinner 70 can be made of suitable nonmagnetic material, hollowed out and fitted with a cap 78 in the cylindrical portion 74. The sample material is then inserted in the hollow spinner 70 for spinning. The samples of material to be encapsuled in a hollow spinner 70 may be in solid, liquid or gaseous form. In solid form material may be substantially in one piece, or for example in relatively large granules, or in powder form. The materials may be spun over a range of temperatures by heating and/or cooling the gas fed through the tube 68 to support and to drive the spinner 70. The spinner can be inserted in or removed from its chamber between the sleeve 58 and cylinder 52, by first pulling out the spinning apparatus at the supporting member 44 from the spectrometer, and then displacing the sleeve 58 by sliding it axially off the cylinder 52. Finally the sleeve is replaced and the spinning apparatus re-inserted through the supporting member 44.

As thus far described the spinner 70 is spun with the longitudinal axis 80 lying horizontally. Alternatively, however, the supporting tube 42 could be arranged horizontally with the axis 80 extending in the vertical direction and the spinner 70 uppermost. There are decided advantages in using the latter attitude. One is that the spinner positions itself at rest in an attitude for easy formation of the gas bearing. However, even with the spinner in the horizontal attitude, it is confined within the sleeve member 58 to an initial attitude in the recess 60 whereby it will assume the proper attitude for spinning as soon as the gas flow forms a gas bearing.

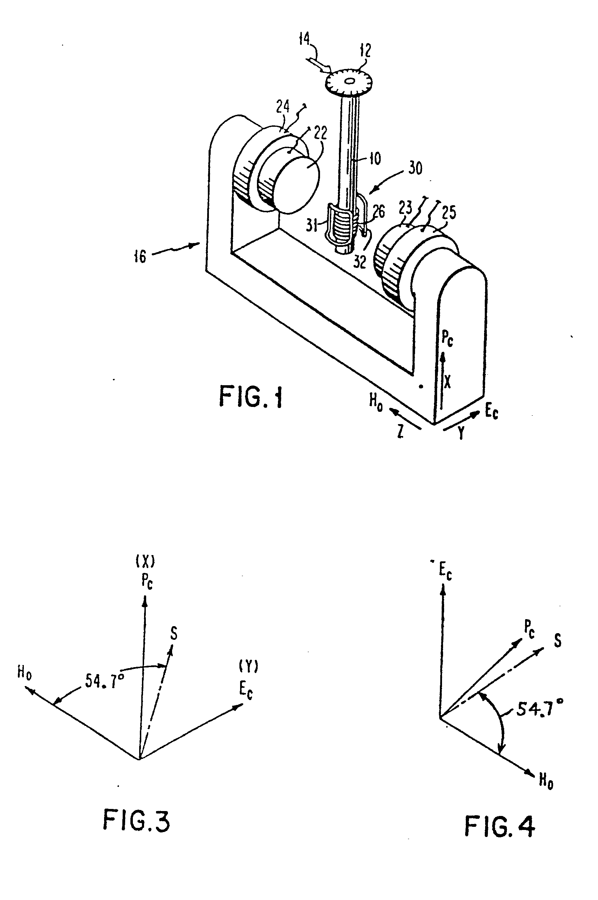

Fig. 3 is a vector diagram illustrating the three dimensional relationships between the spin axis S (80), the magnetic field axis $H_o$, the $E_c$ axis and the $P_c$ axis when the spinning apparatus is arranged as shown in Fig. 1, while Fig. 4 is a similar diagram for the relationships when the supporting tube 42 is horizontal. In both of these diagrams, the spin axis S is arranged at 54.7° from the magnetic axis Z in the plane defined by the magnetic axis Z and the exciting axis Y. The particular secondary designations of X, Y, and Z axes are conventional in NMR spectroscopy.

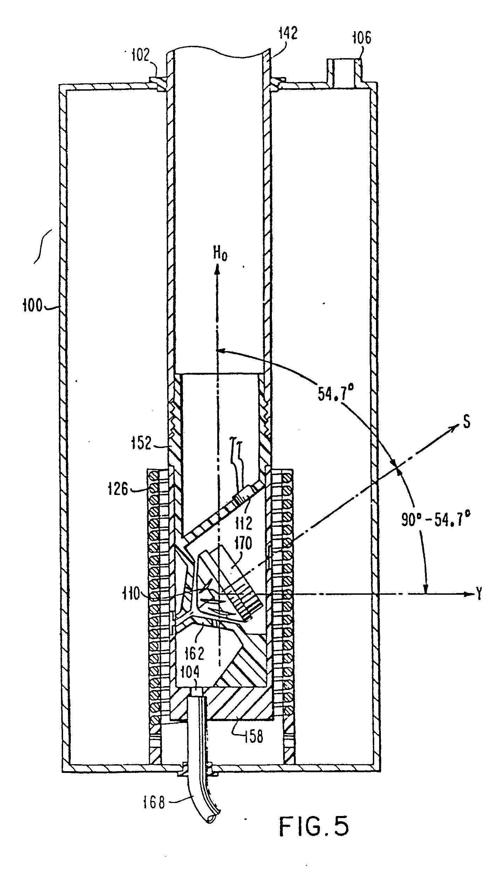

Another embodiment of the invention is shown in Fig. 5. A container 100 made of aluminum, or some other non-magnetic material, is arranged in the magnetic field $H_o$ wherein the lines of flux extend in the direction of the longitudinal axis of the container 100, and the spinning apparatus is inserted in the container with the longitudinal axes coinciding. The spinning apparatus is held in place by a resilient seal 102, in which the tubing 142 is gripped sufficiently tight to hold it in place during operation. Wherever possible, in this description, reference numerals for the different components are the same as for those in the earlier description, but raised by 100. A body member in the form of cylinder 152, with a cylinder sleeve 158 slips inside a sensing coil 126 and is similar to that previously described, except that the angle of the spinning axis S is at a desired predetermined angle, shown as 54.7° from the vertical. This angle is most frequently used. However, should adjustability of the angle of the spinner 170 be desired, it is contemplated that the cylinder 152 be provided with a pivotal portion for the spinner, which is pivotable by means of an axle or a spherical joint with center at the intersection 110 of the $H_o$ and the Y axes, whereby the spinner axis may be adjusted prior to the insertion of the spinning apparatus into the container 100. The structure of the spinning apparatus is otherwise much the same as before. Gas is directed through tubing 168 into an annular manifold and thence through gas jet orifices for forming a gas bearing and for driving the rotor 170. Escaping gas passes through gas exhaust apertures in the cylindrical wall of the sleeve 158, and by way of the container 100 to exhaust vent 106. The sample is thus maintained in an atmosphere of the gas. A temperature sensing device 112 is arranged to monitor the temperature in the vicinity of the rotor 170. Alternatively, a thermometer may be mounted with the sensitive tip at a desired point within the container 100.

The spinning apparatus is made of any machineable non-magnetic material, and is preferably nonmetallic as well, in the interests of avoiding eddy currents and the like.

A form of boron nitride has been used. In one case the spinning apparatus was made by machining polychlorotrifluoroethylene stock. Other suitable materials will be suggested to those skilled in the art.

## Claims

1. Spinning apparatus for nuclear magnetic resonance spectrometers, characterised by a non-magnetic assembly comprising a body member (52) having a sleeve (58) which is displaceable from a first position relative to the body member to allow a sample or sample holder (70) to be inserted in or removed from a chamber formed between the body member and the sleeve when in the said first position, the chamber having a gas flow path therethrough for forming a gas bearing on which the sample or sample holder is rotatable by the gas.

2. Apparatus as claimed in claim 1 in which the body member has a cone-shaped recess (60) for receiving a cone-headed portion (72) of the sample or sample holder, there being gas jet orifices (66) in the body member opening at the surface of said cone-shaped recess for directing gas jets to rotate the sample or sample holder and provide the gas for the gas bearing.

3. Apparatus as claimed in claim 2 in which the centre of the base of the cone-shaped recess is at or adjacent a longitudinal median plane of the body member.

4. Apparatus as claimed in claim 3 in which the sleeve has at least one gas exhaust aperture on the side of said longitudinal median plane opposite to the apex of the cone-shaped recess.

5. Apparatus as claimed in any preceding claim in which the sleeve is tubular and coacts with surfaces of the body member lying on a cylinder.

6. Apparatus as claimed in claim 5 when dependent on claim 2, 3 or 4, in which one of said surfaces of the body member coacting with the sleeve has a gas exhaust aperture (82) communicating with the apex of the cone-shaped recess and registering with an associated exhaust aperture (84) in the sleeve.

7. Apparatus as claimed in claim 2, 3, 4 or 6 in which the cone-headed portion of the sample or sample holder has an apex section and a skirt section, the apex section having a larger cone angle than the skirt section.

8. Apparatus as claimed in claim 2, 3, 4 or 6 in which said body member and said sleeve form a manifold chamber (64) with which said gas jet orifices communicate.

9. Apparatus as claimed in any preceding claim having a hollow sample holder with a releasable closure (78).

10. Apparatus as claimed in any preceding claim in which the body member has a longitudinal axis, and the angle between that axis and the spin axis of the sample or sample holder is between 45° and 90° inclusive.

11. Apparatus as claimed in claim 10 in which said angle is 90°.

12. Apparatus as claimed in claim 10 in which said angle is 54.7°.

13. Nuclear magnetic resonance spectrometer including spinning apparatus as claimed in any preceding claim, the spinning apparatus being mounted so that the spin axis of the sample or sample holder lies in the plane defined by a high dc magnetic field axis (Z) of the spectrometer, and the axis (Y) of an excitation coil (30) of the spectrometer associated with the spinning apparatus.

14. Nuclear magnetic resonance spectrometer as claimed in claim 13 in which the spinning apparatus can be pulled out from, and rotated in, the spectrometer for changing the sample or sample holder, and to change the relative position of the spin axis.

## Revendications

1. Dispositif d'entraînement en rotation pour spectromètre à résonance magnétique nucléaire, caractérisé en ce qu'il comprend un ensemble non magnétique composé d'un corps (52) portant un manchon (58) mobile depuis une première positon par rapport au corps afin de permettre l'introduction ou le retrait d'un échantillon ou porte-échantillons (70) dans ou d'une chambre formée entre le corps et le manchon lorsque celui-ci est dans ladite première position, la chambre étant traversée par un courant gazeux formant un palier pneumatique sur lequel l'échantillon ou porte-échantillons peut être entraîné en rotation par le gaz.

2. Dispositif selon la revendication 1, caractérisé en ce que le corps présente un évidement cônique (60) recevant la tête cônique (72) de l'échantillon ou du porte-échantillons, des orifices (66) de jets de gaz ménagés dans le corps débouchant à la surface dudit évidement cônique pour diriger des jets de gaz afin que ceux-ci entraînent un échantillon ou le porte-échantillons en rotation et fournissent le gaz pour le palier pneumatique.

3. Dispositif selon la revendication 2, caractérisé en ce que le centre de la base de l'évidement cônique est dans ou adjacent à un plan médian longitudinal du corps.

4. Dispositif selon la revendiction 3, caractérisé en ce que le manchon présente au moins un orifice de sortie de gaz du côté dudit plan médian longitudinal opposé à la pointe de l'évidement cônique.

5. Dispositif selon l'une des revendications précédentes, caractérisé en ce que le manchon est tubulaire et coopère avec des surfaces du corps reposant sur un cylindre.

6. Dispositif selon la revendication 5 lorsque celle-ci dépend des revendications 2, 3 ou 4, caractérisé en ce que l'une desdites surfaces dudit corps coopérant avec le manchon présente un orifice de sortie de gaz (82) communiquant avec la pointe de l'évidement cônique et en correspondance avec un orifice de sortie associé (84) du manchon.

7. Dispositif selon l'une des revendications 2, 3, 4 ou 6 caractérisé en ce que la pointe cônique de l'échantillon ou du porte-échantillons est composée d'une pointe et d'une jupe, la pointe ayant un angle de cône plus grand que la jupe.

8. Dispositif selon la revendication 2, 3, 4 ou 6 caractérisé en ce que ledit corps et ledit manchon forment un collecteur (64) communiquant avec lesdits orifices à jet de gaz.

9. Dispositif selon l'une des revendications précédentes, caractérisé en ce qu'il comprend un porte-échantillons creux à élément de fermeture (78) amovible.

10. Dispositif selon l'une des revendications précédentes, caractérisé en ce que le corps présente un axe longitudinal et en ce que l'angle que fait cet axe avec l'axe de rotation de l'échantillon ou du porte-échantillons est compris entre 45 et 90° inclus.

11. Dispositif selon la revendication 10, caractérisé en ce que ledit angle est de 90°.

12. Dispositif selon la revendication 10, caractérisé en ce que ledit angle est de 54,7°.

13. Spectromètre à résonance magnétique nucléaire comprenant le dispositif d'entraînement en rotation tel que revendiqué dans l'une des précédentes revendications, caractérisé en ce que le dispositif d'entraînement en rotation est monté de façon l'axe de rotation de l'échantillon ou du porte-échantillons soit dans le plan défini par l'axe (Z) d'un champ magnétique de courant continu élevé du spectromètre, et l'axe (Y) d'un enroulement d'excitation (30) du spectromètre associé au dispositif d'entraînement en rotation.

14. Spectromètre à résonance magnétique nucléaire selon la revendication 13 caractérisé en ce que le dispositif d'entraînement en rotation peut être retiré du spectrométre en entraîné en rotation dans celui-ci pour changer l'échantillon ou le porte-échantillons et pour modifier la position relative de l'axe de rotation.

**Patentansprüche**

1. Rotationsvorrichtung fuer magnetische Kernresonanzspektrometer, gekennzeichnet durch eine nichtmagnetische Anordnung enthaltend ein Bauteil (52) mit einer Huelse (58), die aus einer ersten Position relativ zum Bauteil so verschiebbar ist, dass ein Muster oder Musterhalter (70) in eine Kammer hinein oder aus dieser heraus bewegt werden kann, die zwischen dem Bauteil und der Huelse gebildet wird, wenn sich diese in der genannten ersten Position befindet, wobei sich durch die Kammer ein Gasflussweg erstreckt zur Bildung eines Gaslagers, auf welchem das Muster oder der Musterhalter durch das Gas in Drehung versetzt werden kann.

2. Vorrichtung nach Anspruch 1, in welcher das Bauteil eine kegelfoermige Vertiefung (60) zur Aufnahme eines Kegelkopf-teiles (72) des Musters oder Musterhalters aufweist, wobei Gasstrommuendungen (66) im Bauteil vorgesehen sind, welche an der Oberflaeche dieser kegelfoermigen Vertiefung muenden und Gasstroeme ausstossen, um Muster oder Musterhalter in Drehung zu versetzen und das Gas fuer das Gaslager zu liefern.

3. Vorrichtung nach Anspruch 2, in welcher sich das Zentrum der Basis der kegelfoermigen Vertiefung bei oder neben einer mittleren Laengsebene des Bauteiles befindet.

4. Vorrichtung nach Anspruch 3, in welcher die Huelse mindestens eine Gasaustrittsoeffnung auf der dem Scheitelpunkt der kegelfoermigen. Vertiefung gegenueberliegenden Seite der oben genannten mittleren Laengsebene aufweist.

5. Vorrichtung nach einem der vorhergehenden Anspruche, in welcher die Huelse roehrenfoermig ist und mit den Oberflaechen des Bauteiles zusammenwirkt, das auf einem Zylinder liegt.

6. Vorrichtung nach Anspruch 5, wenn zurueckbezogen auf Anspruch 2, 3 oder 4, in welcher eine der Oberflaechen des mit der Huelse zusammenwirkenden Bauteiles eine Gasaustrittsoeffnung (82) aufweist, die zum Scheitelpunkt der kegelfoermigen Vertiefung fuehrt und einer zugeordneten Austrittsoeffnung (84) in der Huelse entspricht.

7. Vorrichtung nach den Anspruenchen 2, 3, 4 oder 6, in welcher der kegelkopffoermige Teil des Musters oder Musterhalters einen Scheitelpunktabschnitt und einen Umhuellungsabschnitt aufweist, wobei der Scheitelpunktabschnitt einen groesseren Kegelwinkel aufweist als der Umheullungsabschnitt.

8. Vorrichtung nach den Anspruechen 2, 3, 4 oder 6, in welcher das genannte Bauteil und die genannte Huelse eine Verzweigungskammer (64) bilden, mit welcher die oben genannten Gasstrommuendungen in Verbindung stehen.

9. Vorrichtung nach einem der vorhergehenden Ansprueche, mit einem hohlen Musterhalter mit einem loesbaren Deckel (78).

10. Vorrichtung nach einem der vorhergehenden Ansprueche, in welcher das Bauteil eine Laengsachse aufweist, und der Winkel zwischen dieser Achse und der Rotationsachse des Musters oder Musterhalters zwischen 46 grad und 90 grad einschliesslich betraegt.

11. Vorrichtung nach Anspruch 10, in welcher der genannte Winkel 90 grad betraegt.

12. Vorrichtung nach Anspruch 10, in welcher der genannte Winkel 54,7 grad betraegt.

13. Magnetisches Kernresonanz-spektrometer mit Rotationsvorrichtung nach einem der vorhergehenden Ansprueche, worin die Rotationsvorrichtung so montiert ist, dass die Rotationsachse von Muster oder Musterhalter sich in der Ebene befindet, die durch eine hohe magnetische Gleichstrom-feldachse (Z) des Spektrometers definiert ist, und worin die Achse (Y) einer Erregungsspule (30) des Spektrometers der Rotationsvorrichtung zugeordnet ist.

14. Magnetisches Kernresonanz-spektrometer nach Anspruch 13, in welchem die Rotationsvorrichtung aus dem Spektrometer gezogen und darin gedreht werden kann, um Muster oder Musterhalter auszuwechseln und die Lager der Rotationsachse zu aendern.

FIG. 2

FIG. 1

FIG. 3

FIG. 4

FIG.5